(19) Europäisches Patentamt
European Patent Office
Office européen des brevets

(11) EP 4 632 525 A2

(12) **EUROPEAN PATENT APPLICATION**

(43) Date of publication:
**15.10.2025 Bulletin 2025/42**

(21) Application number: **25168033.6**

(22) Date of filing: **02.04.2025**

(51) International Patent Classification (IPC):
**G05F 1/652** *(2006.01)*      **G05F 3/26** *(2006.01)*

(52) Cooperative Patent Classification (CPC):
**G05F 1/652; G05F 3/262**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.04.2024 US 202463633320 P**
**07.02.2025 US 202519048681**

(71) Applicant: **Power Integrations, Inc.**
**San Jose, CA 95138 (US)**

(72) Inventor: **Sato, Takayasu**
**San Jose, 95118 (US)**

(74) Representative: **Fish & Richardson P.C.**
**Highlight Business Towers**
**Mies-van-der-Rohe-Straße 8**
**80807 München (DE)**

(54) **AN INTERFACE CIRCUIT USING MIRRORED CURRENT FEEDBACK TO REDUCE INPUT IMPEDANCE**

(57) An interface circuit using mirrored current feedback to reduce input impedance is disclosed herein. According to the teachings herein, the interface circuit includes a current mirror and an input circuit path. Shunt feedback via a return circuit path provides a mirrored current to an interface input thereby reducing an input impedance of the interface circuit. By virtue of shunt feedback, the input impedance of the interface circuit is reduced relative to the impedance of the input circuit path. In this manner, input impedance of the interface circuit may be reduced without changing the impedance of the input circuit path.

FIG. 1

EP 4 632 525 A2

**Description**

<u>CROSS-REFERENCE TO RELATED APPLICATION(S)</u>

This application claims the benefit of U.S. Provisional Application No. 63/633,320, filed on April 12, 2024, incorporated by reference herein in its entirety.

<u>BACKGROUND INFORMATION</u>

<u>Field of the Disclosure</u>

The present invention relates to interface circuits, and more specifically to interface circuits using mirrored current feedback.

<u>Background</u>

Controllers and systems, including switch mode power supply topologies (e.g., flyback converter topologies), may often include interface circuits (i.e., circuitry) between different types of circuit blocks, circuits, circuitry, and/or circuit components. For instance, an interface circuit between a sensor (e.g., sensor circuit) and a gain stage (e.g., an amplifier or amplifier circuitry) may condition signals from the sensor before they reach the amplifier input.

Due to their high efficiency, small size, and low weight, switched mode power converters are often used in powering today's electronics from conventional wall sockets. The switched mode power converter controller may be part of a closed-loop system for regulating output power as a function of one or more system signals (e.g., output voltage).

During operation, a switch is gated according to a switching cycle based on system or controller configuration (e.g., flyback configuration). Duty cycle (typically the ratio of the on time of the switch to the total switching period), switching frequency, or number of pulses per unit time of the switch may be varied to regulate the output (e.g., output power) based on sensed, feedback signals.

<u>Summary of the Disclosure</u>

This disclosure presents a circuit approach to improve input impedance in electronic circuits like the above-mentioned interface circuits. Input impedance may include resistance from an input circuit path. The input circuit path may have components and circuit elements which are necessary for circuit operation. Unfortunately, the components and circuit elements may present impedance which can limit or degrade circuit performance. For instance, resistance may degrade switching performance.

Therefore, a problem occurs when, due to system specifications, the resistance cannot be reduced to improve circuit performance. The following disclosure presents a way to overcome this problem by using a feedback approach. A feedback path is introduced at the input to effectively reduce the input impedance without changing original components of the input circuit path. In this way the components may function as originally intended while the feedback path enhances performance.

<u>BRIEF DESCRIPTION OF THE DRAWINGS</u>

Non-limiting and non-exhaustive embodiments of an interface circuit using mirrored current feedback to reduce input impedance are described with reference to the following figures, wherein like reference numerals refer to like parts throughout the various views unless otherwise specified.

**FIG.** 1 illustrates a flyback converter according to the teachings herein.
**FIG. 2A** illustrates an interface circuit according to the teachings herein.
**FIG. 2B** illustrates an interface circuit according to the embodiment of FIG. 2A.
**FIG. 2C** illustrates an interface circuit according to an embodiment.
**FIG. 3A** illustrates an interface circuit according to the teachings herein.
**FIG. 3B** illustrates an interface circuit according to the embodiment of FIG. 3A.
**FIG. 3C** illustrates an interface circuit according to an embodiment.
**FIG.** 4 illustrates an interface circuit according to an embodiment.
**FIG. 5A** illustrates an interface circuit according to another embodiment.
**FIG. 5B** illustrates a thermal shutdown circuit according to the embodiment of FIG. 5A.
**FIG. 5C** illustrates a bias circuit according to the embodiment of FIG. 5A.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the teachings herein. Also, common but well-understood elements that are useful or necessary in a commercially feasible embodiment are often not depicted in order to facilitate a less obstructed view of these various embodiments of an interface circuit using mirrored current feedback to reduce input impedance.

DETAILED DESCRIPTION

In the following description, numerous specific details are set forth in order to provide a thorough understanding of an interface circuit using mirrored current feedback to reduce input impedance. It will be apparent, however, to one having ordinary skill in the art that the specific detail need not be employed to practice the teachings herein. In other instances, well-known materials or methods have not been described in detail in order to avoid obscuring the present disclosure.

Reference throughout this specification to "one embodiment", "an embodiment", "one example" or "an example" means that a particular feature, structure, or characteristic described in connection with the embodiment or example is included in at least one embodiment of an interface circuit using mirrored current feedback to reduce input impedance. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a logic circuit, or other suitable components that provide the described functionality. In addition, it is appreciated that the figures provided herewith are for explanation purposes to persons ordinarily skilled in the art and that the drawings, including waveforms and graphs, are not necessarily drawn to scale.

In the context of the present application, when a transistor is in an "off-state" or "off" the transistor blocks current and/or does not substantially conduct current. Conversely, when a transistor is in an "on-state" or "on" the transistor is able to substantially conduct current. By way of example, in one embodiment, a high-voltage transistor comprises an N-channel metal-oxide-semiconductor (NMOS) field-effect transistor (FET) with the high-voltage being supported between the first terminal, a drain, and the second terminal, a source. Also, for purposes of this disclosure, "ground" or "ground potential" refers to a reference voltage or potential against which all other voltages or potentials of an electronic circuit or integrated circuit (IC) are defined or measured.

As discussed above, a flyback converter is one type of switch mode power supply topology. A flyback converter is a SMPS topology that includes isolation between primary and secondary windings of an energy transfer element (e.g., a magnetic component or coupled inductor). Components and circuitry connected and referenced to the primary winding are often referred to as primary side components/circuitry. Similarly, components and circuitry connected and referenced to the secondary winding are often referred to as secondary side components/circuitry. In this way the flyback converter is configured to have a primary side and a secondary side.

Also, as discussed above, a switch may be gated or controlled according to a switching cycle based on system or controller configuration. During operation, a switch mode power supply often uses one or more controllers to regulate and transfer power based on signal information such as output voltage and/or current.

In a flyback configuration, controllers may include primary side controllers and/or secondary side controllers; and there may be a need to communicate signal information from the secondary side to the primary side. For instance, to regulate output power on the secondary side, a primary side controller may require the value of the output voltage at the secondary side.

One way to communicate signal information is by means of an optocoupler. For instance, a current (e.g., a phototransistor current) may be generated by the optocoupler in proportion to the output voltage.

The current (e.g., phototransistor current) may be provided to the primary side controller which, in response, may vary the switching of a primary side switch to adjust/regulate power (e.g., output power).

The primary side controller may include an interface circuit or circuitry to receive the current (e.g., phototransistor current) and to convert the current into a usable internal signal. For instance, interface circuitry may convert the current (e.g., phototransistor current) into a voltage. Alternatively, and additionally, interface circuitry may amplify, attenuate, or level shift the current (e.g., phototransistor current).

According to the teachings herein, a SMPS may be treated as a system whereby transient response and switching can be related to system bandwidth. System bandwidth may relate to the impedance of a system loop. The system behavior (e.g., switching behavior and bandwidth) of a flyback converter may be determined, at least in part, by a dominate pole relating to the electrical coupling of the optocoupler and interface circuit/circuitry.

For example, the output of the optocoupler may be connected at the input of the interface circuit/circuitry. An extra pole is created by the interface. The extra pole may be related, at least in part, to capacitance at the output of the optocoupler and resistance at the input of the interface circuit/circuitry.

To meet the fundamental need of improving switching performance, the extra pole may be reduced either by reducing capacitance, by reducing resistance, and/or by reducing a combination of both. Unfortunately, reducing capacitance of the optocoupler may not be an option. Therefore, reducing resistance at the input of the interface circuit/circuitry may be the preferred way to improve bandwidth.

One way to reduce resistance at the input of the interface circuit/circuitry is to reduce the impedance of an input circuit path. For instance, non-linear devices (e.g., field effect transistors and the like) can be made with larger area to reduce on resistance and any series resistors can be designed to have lower resistance.

Unfortunately, there may be fundamental or conflicting specifications which make reducing the impedance of the input circuit path more challenging. For instance, when the input circuit path includes electrostatic discharge (ESD) resistors/resistance, then an ESD voltage specification may prevent the resistor/resistance from being reduced further. Additionally, it may be impractical and costly to increase the area of a non-linear device (e.g., a field effect transistor) to reduce its on resistance.

Accordingly, there is a need to find alternative ways to reduce the input impedance of an interface circuit and/or interface circuitry.

An interface circuit using mirrored current feedback to reduce input impedance is disclosed herein. According to the teachings herein, the interface circuit includes a current mirror and an input circuit path. Shunt feedback via a return circuit path provides a mirrored current to an interface input thereby reducing an input impedance of the interface circuit. By virtue of shunt feedback, the input impedance of the interface circuit is reduced relative to the impedance of the input circuit path. In this manner input impedance of the interface circuit may be reduced without changing the impedance of the input circuit path.

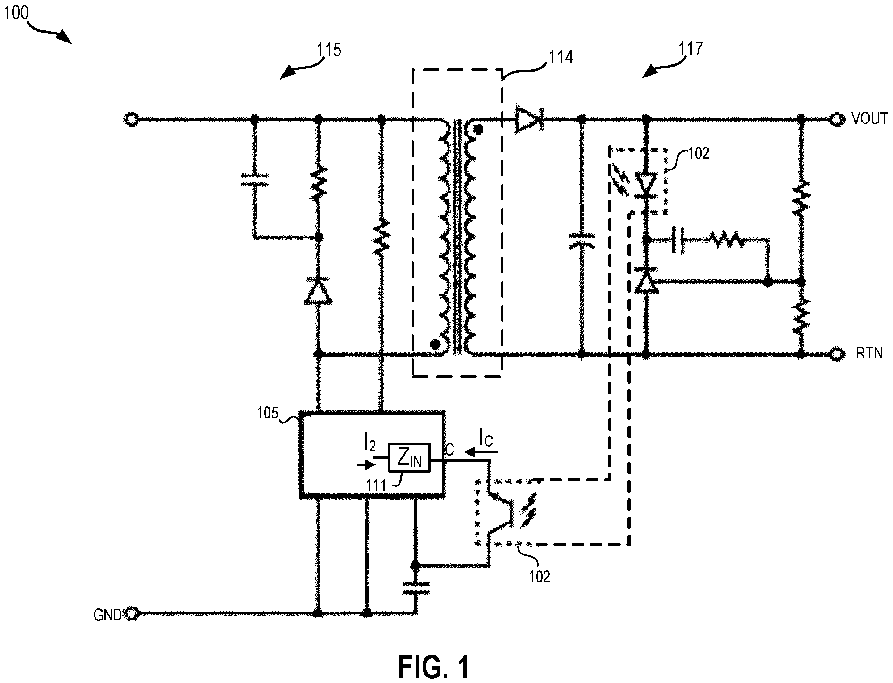

**FIG. 1** illustrates a flyback converter 100 according to the teachings herein. Flyback converter 100 includes an energy transfer element 114. As discussed above, energy transfer element 114 (e.g., a transformer and/or coupled inductor/inductance) may provide isolation (i.e., galvanic isolation) between a primary side 115 and secondary side 117. The primary side 115 is referenced to a primary ground GND and the secondary side 117 is referenced to a secondary ground RTN.

Flyback converter 100 also includes an optocoupler 102 and a switcher circuit 105. Switcher circuit 105 may be an integrated switcher circuit including a primary switch (not illustrated). The optocoupler 102 may communicate information relating to output voltage VOUT from the secondary side 117 to the switcher circuit 105 on the primary side 115 by generating current Ic (i.e., phototransistor current Ic).

Switcher circuit 105 may include an interface circuit 111 to convert current Ic at interface input C to an internal, usable current $I_2$. According to the teachings herein, the interface circuit 111 may use mirrored current feedback to improve (i.e., to reduce) input impedance $Z_{IN}$. Reducing input impedance $Z_{IN}$ may advantageously improve switching and increase system bandwidth.

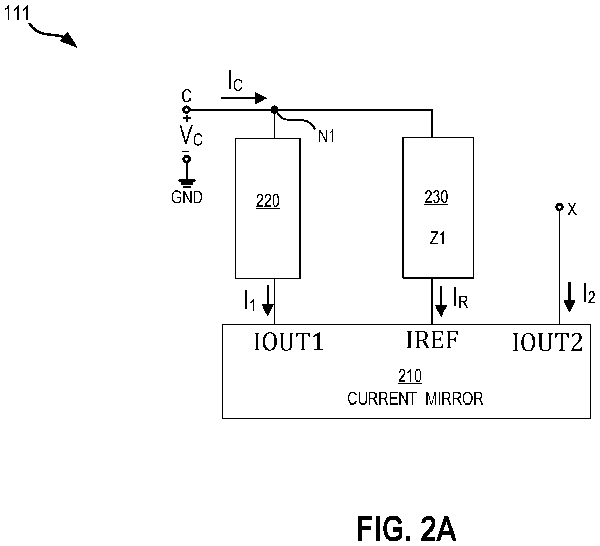

**FIG. 2A** illustrates an interface circuit 111 according to the teachings herein. The interface circuit 111 includes a current mirror 210, a circuit path 220, and a circuit path 230. Circuit path 220 and circuit path 230 are electrically coupled (electrically connected) at node N1. Current Ic is the current at interface input C and may be referred to as input current Ic. Voltage Vc is the voltage at interface input C relative to ground GND; and the input impedance $Z_{IN}$ of interface circuit 111 may be the impedance at interface input C.

As illustrated circuit path 230 is electrically connected between node N1 and input IREF of current mirror 210; and circuit path 220 is electrically connected between node N1 and output IOUT1 of current mirror 210.

Interface input C is electrically connected (coupled) to node N1. Although not illustrated, there may be additional components connected between interface input C and node N1; and the terms "electrically connected (coupled)" and/or "connected (coupled)" do not limit or exclude additional components herein. Additionally, input IREF and output IOUT1 may also be referred to as current mirror input IREF and current mirror output IOUT1, respectively.

Accordingly, circuit path 220 is electrically coupled (connected) between interface input C and current mirror output IOUT1; and circuit path 230 is electrically coupled between interface input C and current mirror input IREF.

Current $I_R$ is the current in circuit path 230. Current $I_R$ is the current provided to (received by) current mirror 210 at current mirror input IREF and may be referred to as reference current $I_R$.

Current $I_1$ is the current in circuit path 220 to current mirror output IOUT1. As described herein, current mirror 210 may generate current $I_1$ in proportion to current $I_R$; and current $I_1$ may be referred to as output current $I_1$ and/or as mirrored current $I_1$. For instance, current mirror 210 may generate current $I_1$ to be related to current $I_R$ by equation EQ. 1 in terms of a ratio K, the ratio of current $I_1$ to current $I_R$.

$$I_1 = K\, I_R \qquad\qquad \text{EQ. 1}$$

Circuit path 230 may be an input circuit path of interface circuit 111 and may have impedance Z1. Additionally, in the absence of circuit path 220, the input impedance $Z_{IN}$ at interface input C may be determined by impedance Z1. As described herein, there is a need to reduce input impedance $Z_{IN}$ of interface circuit 111 relative to impedance Z1.

According to the teachings herein, circuit path 220 may be connected to circuit path 230 at node N1 so that current $I_R$ is less than current Ic and input impedance $Z_{IN}$ at interface input C is reduced relative to impedance Z1. Connecting circuit path 220 to circuit path 230 at node N1 provides shunt feedback; thus, circuit path 220 may also be referred to as a return circuit path 220 and current $I_1$ may additionally be referred to as a return current $I_1$. Since the current $I_1$ is a mirrored current $I_1$ from current mirror 210, the "shunt" feedback may also be referred to as "mirrored current" feedback.

According to feedback (control) theory, the interface circuit 111 may be treated as a closed loop system where interface input C is a system input. Shunt feedback may advantageously decrease the input impedance at interface input C relative to impedance Z1. For instance, the input impedance $Z_{IN}$ may be determined by the relationship of equation EQ. 2, where ratio K (ratio of current $I_1$ to current $I_R$) is referred to as return ratio K.

$$Z_{IN} = Z1/(1+K) \qquad EQ. 2$$

The output X of interface circuit 111 is electrically connected to output IOUT2 of current mirror 210 and may be referred to as current mirror output IOUT2. Current $I_2$ at current mirror output IOUT2 may also be generated by current mirror 210 and may be referred to as output current $I_2$ and/or as mirrored current $I_2$.

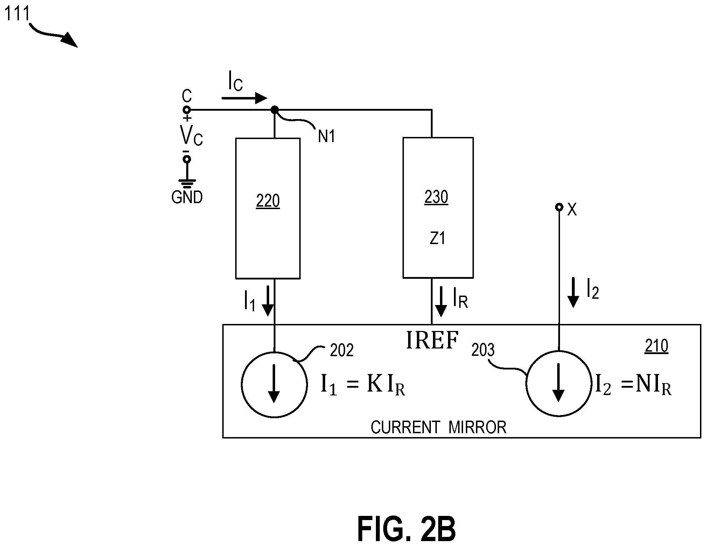

**FIG. 2B** illustrates an interface circuit 111 according to the embodiment of FIG. 2A. Current mirror 210 includes a current source 202 and a current source 203. As illustrated, current source 202 may generate current $I_1$ in proportion to current $I_R$ by ratio K (return ratio K). According to teachings herein, the input impedance $Z_{IN}$ at interface input C may decrease as return ratio K increases. A practical value of return ratio K may be greater than or equal to one and may have an upper limit based on alternating current (ac) stability considerations.

Also as illustrated, current source 203 may generate current $I_2$ in proportion to current $I_R$ by ratio N according to the relationship of equation EQ. 3.

$$I_2 = N\, I_R \qquad EQ. 3$$

According to feedback and circuit theory, input current Ic may be determined, at least in part, by the sum of current $I_1$ and current $I_R$. Therefore, input current Ic may be related to current $I_R$ by equation EQ. 4.

$$I_C = (1+K)\, I_R \qquad EQ. 4$$

Accordingly, the interface circuit 111 may provide a usable current $I_2$ in response to input current Ic as determined by equation EQ. 5.

$$I_2 = N\, I_C/(1+K) \qquad EQ. 5$$

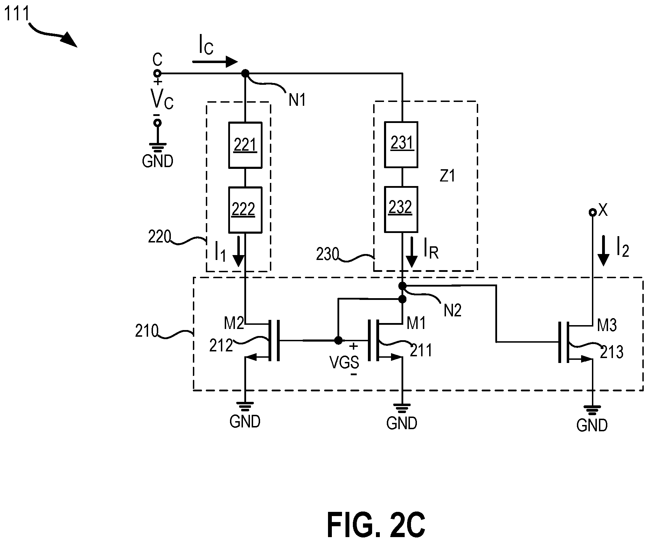

**FIG. 2C** illustrates an interface circuit 111 according to an embodiment. Circuit path 220 includes a component 221 and a component 222 electrically connected in series. In some embodiments there may be greater or fewer than two components 221, 222. According to the teachings herein, the input impedance $Z_{IN}$ may be independent of the impedance due to components (e.g., components 221, 222) of circuit path 220.

Circuit path 230 includes component 231 and component 232 electrically connected in series. Therefore, impedance Z1 comprises an impedance of component 231 and an impedance of component 232. In some embodiments there may be greater or fewer than two components 231, 232.

Current mirror 210 comprises N-channel field effect transistor (NFET) 211, NFET 212, and NFET 213. NFET 211 has a size (e.g., area) scale factor M1. NFET 212 has a size scale factor M2; and NFET 213 has a size scale factor M3. The drain of NFET 211 is electrically coupled to circuit path 230; accordingly, the drain of NFET 211 may be the current mirror input IREF. The drain of NFET 212 is electrically coupled to circuit path 220; accordingly, the drain of NFET 212 may be the current mirror output IOUT1. The gate of NFET 212 is electrically connected to the gate of NFET 211, and the source of NFET 212 is electrically connected to ground GND. The drain of NFET 213 is electrically coupled to output X; accordingly, the drain of NFET 213 may be the current mirror output IOUT2. The gate of NFET 213 is electrically connected to the gate of NFET 211, and the source of NFET 213 is electrically connected to ground GND.

As illustrated, NFET 211 is diode connected (i.e., the gate of NFET 211 is electrically connected to the drain of NFET 211). NFET 211 receives current $I_R$ and provides voltage VGS (i.e., gate-to-source voltage VGS) that changes as current $I_R$ changes. Therefore, NFET 211 may convert current $I_R$ into voltage VGS.

NFET 212 receives voltage VGS from NFET 211 and provides current $I_1$ as a function of voltage VGS. With reference to FIG. 2B, NFET 212 may operate as current source 202 and ratio K may be determined, at least in part, by the ratio of scale factor M2 to scale factor M1 (i.e., equation EQ. 6).

$$K = M2/M1 \qquad \text{EQ. 6}$$

Alternatively, and additionally, ratio K may be determined, at least in part, by the transconductance gm1 of NFET 211 and transconductance gm2 of NFET 212 (i.e., equation EQ. 7).

$$K = gm2/gm1 \qquad \text{EQ. 7}$$

NFET 213 receives voltage VGS from NFET 211 and provides current $I_2$ as a function of voltage VGS. With reference to FIG. 2B, NFET 213 may operate as current source 203 and ratio N may be determined, at least in part, by the ratio of scale factor M3 to scale factor M1 (i.e., equation EQ. 8).

$$N = M3/M1 \qquad \text{EQ. 8}$$

Alternatively, and additionally, ratio N may be determined, at least in part, by the transconductance gm1 of NFET 211 and transconductance gm3 of NFET 213 (i.e., equation EQ. 9).

$$N = gm3/gm1 \qquad \text{EQ. 9}$$

According to the teachings herein, by connecting return circuit path 220 to circuit path 230 at node N1, the input impedance $Z_{IN}$ of interface circuit 111 will be related to impedance Z1 of circuit path 230 and to the ratio K (i.e., equation EQ. 2). Therefore, if the impedance Z1 represents the impedance of the interface circuit 111 in the absence of return circuit path 220, then the introduction of return circuit path 220 advantageously reduces input impedance $Z_{IN}$ by virtue of shunt feedback. Moreover, the input impedance $Z_{IN}$ may be (substantially) independent of impedance in the return circuit path 220.

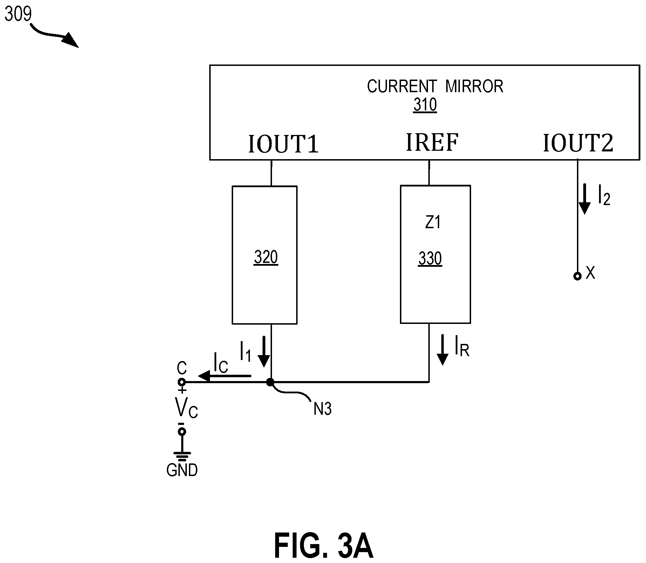

**FIG. 3A** illustrates an interface circuit 309 according to the teachings herein. The interface circuit 309 includes a current mirror 310, a circuit path 320, and a circuit path 330. Circuit path 320 and circuit path 330 are electrically coupled (electrically connected) at node N3. The input impedance $Z_{IN}$ of interface circuit 309 may be the impedance at interface input C.

As illustrated circuit path 330 is electrically connected between node N3 and input IREF of current mirror 310; and circuit path 320 is electrically connected between node N3 and output IOUT1 of current mirror 310.

Interface input C is electrically connected (coupled) to node N3. Accordingly, circuit path 320 is electrically coupled (connected) between interface input C and current mirror output IOUT1; and circuit path 330 is electrically coupled between interface input C and current mirror input IREF.

Current $I_R$ is the current in circuit path 330. Current $I_R$ is the current provided by (received from) current mirror 310 at current mirror input IREF and may be referred to as reference current $I_R$. Current $I_1$ is the current in circuit path 320 from current mirror output IOUT1 and may also be referred to as output current $I_1$. Current mirror 310 may generate current $I_1$ in proportion to current $I_R$ (i.e., equation EQ. 1). Therefore, as discussed above, current $I_1$ may also be referred to as mirrored current $I_1$.

Circuit path 330 may be an input circuit path of interface circuit 309 and may have impedance Z1. Additionally, in the absence of circuit path 320, the input impedance $Z_{IN}$ at interface input C may be determined by impedance Z1. Like that of interface 111, input impedance $Z_{IN}$ of interface circuit 309 may be reduced relative to impedance Z1.

According to the teachings herein, circuit path 320 may be connected to circuit path 330 at node N3 so that current $I_R$ is less than current Ic and input impedance $Z_{IN}$ at interface input C is reduced relative to impedance Z1. Connecting circuit path 320 to circuit path 330 at node N3 provides shunt feedback; thus, circuit path 320 may also be referred to as a return circuit path 320 and current $I_1$ may additionally be referred to as a return current $I_1$. As discussed above, shunt (mirrored current) feedback may decrease the input impedance $Z_{IN}$ at interface input C according to the relationship of equation EQ. 2.

The output X of interface circuit 309 is electrically connected to output IOUT2 of current mirror 310 and may be referred to as current mirror output IOUT2. Current $I_2$ at current mirror output IOUT2 may also be generated by current mirror 310 and may be referred to as output current $I_2$ and/or as mirrored current $I_2$.

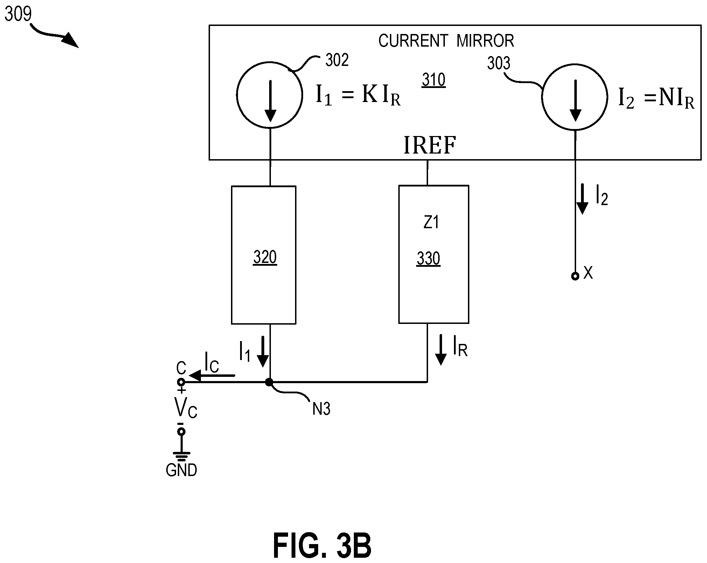

**FIG. 3B** illustrates an interface circuit 309 according to the embodiment of FIG. 3A. Current mirror 310 includes a current source 302 and a current source 303. As illustrated, current source 302 may generate current $I_1$ in proportion to current $I_R$ by ratio K (return ratio K). According to the teachings herein, the input impedance $Z_{IN}$ at interface input C may decrease as return ratio K increases. A practical value of return ratio K may be greater than or equal to one and may have an upper limit based on alternating current (ac) stability considerations.

Also as illustrated, current source 303 may generate current $I_2$ in proportion to current $I_R$ by ratio N according to the relationship of equation EQ. 3.

According to feedback and circuit theory, input current Ic may be determined, at least in part, by the sum of current $I_1$ and current $I_R$. Therefore, input current Ic may be related to current $I_R$ by equation EQ. 4. Accordingly, the interface circuit 309 may provide a usable current $I_2$ in response to input current Ic as determined by equation EQ. 5.

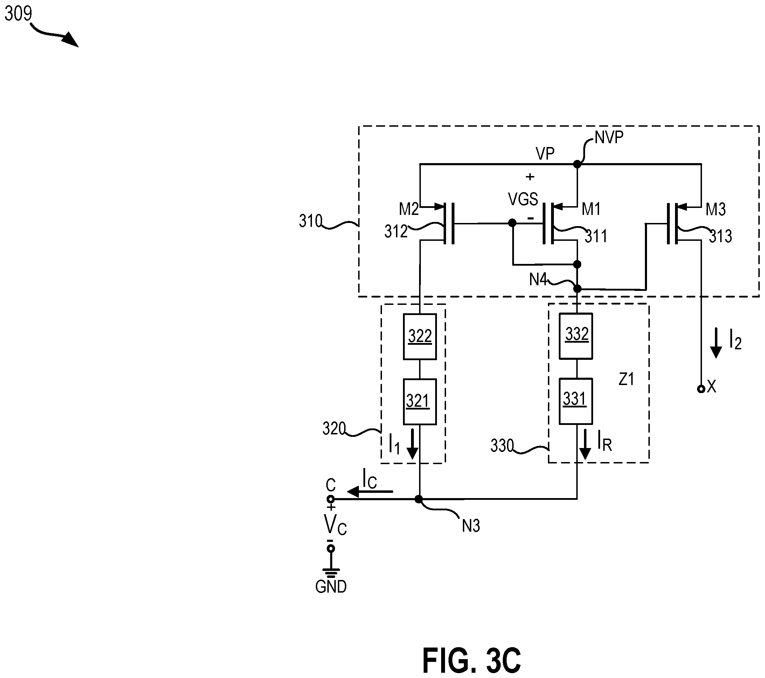

**FIG. 3C** illustrates an interface circuit 309 according to an embodiment. Circuit path 320 includes a component 321 and component 322 electrically connected in series. In some embodiments there may be greater or fewer than two components 321, 322. According to the teachings herein, the input impedance $Z_{IN}$ may be independent of the impedance due to components (e.g., components 321, 322) of circuit path 320.

Circuit path 330 includes component 331 and component 332 electrically connected in series. Therefore, impedance Z1 comprises an impedance of component 331 and an impedance of component 332. In some embodiments there may be greater or fewer than two components 331, 332.

Current mirror 310 comprises P-channel field effect transistor (PFET) 311, PFET 312, and PFET 313. PFET 311 has a size (e.g., area) scale factor M1. PFET 312 has a size scale factor M2; and PFET 313 has a size scale factor M3. The drain of PFET 311 is electrically coupled to circuit path 330; accordingly, the drain of PFET 311 may be the current mirror input IREF.

The drain of PFET 312 is electrically coupled to circuit path 320; accordingly, the drain of PFET 312 may be the current mirror output IOUT1. The gate of PFET 312 is electrically connected to the gate of PFET 311, and the source of PFET 312 is electrically connected to supply node NVP. Supply node NVP receives supply voltage VP. Supply voltage VP may be greater than zero volts.

The drain of PFET 313 is electrically coupled to output X; accordingly, the drain of PFET 313 may be the current mirror output IOUT2. The gate of PFET 313 is electrically connected to the gate of PFET 311, and the source of PFET 313 is electrically connected to supply node NVP.

As illustrated, PFET 311 is diode connected (i.e., the gate of PFET 311 is electrically connected to the drain of PFET 311). PFET 311 generates voltage VGS (i.e., gate-to-source voltage VGS) that changes as current $I_R$ changes. Therefore, PFET 311 may convert current $I_R$ into voltage VGS.

PFET 312 receives voltage VGS from PFET 311 and provides current $I_1$ as a function of voltage VGS. With reference to FIG. 3B, PFET 312 may operate as current source 302 and ratio K may be determined, at least in part, by the ratio of scale factor M2 to scale factor M1 (i.e., equation EQ. 6).

Alternatively, and additionally, ratio K may be determined, at least in part, by the transconductance gm1 of PFET 311 and transconductance gm2 of PFET 312 (i.e., equation EQ. 7).

PFET 313 receives voltage VGS from PFET 311 and provides current $I_2$ as a function of voltage VGS. With reference to FIG. 3B, NFET 313 may operate as current source 303 and ratio N may be determined, at least in part, by the ratio of scale factor M3 to scale factor M1 (i.e., equation EQ. 8).

Alternatively, and additionally, ratio N may be determined, at least in part, by the transconductance gm1 of PFET 311 and transconductance gm3 of PFET 313 (i.e., equation EQ. 9).

According to the teachings herein, by connecting return circuit path 320 to circuit path 330 at node N3, the input impedance $Z_{IN}$ of interface circuit 309 will be related to impedance Z1 of circuit path 330 and to the ratio K (i.e., equation EQ. 2). Therefore, if the impedance Z1 represents the impedance of the interface circuit 309 in the absence of return circuit path 320, then the introduction of return circuit path 320 advantageously reduces input impedance $Z_{IN}$ by virtue of shunt feedback. Moreover, the input impedance $Z_{IN}$ may be (substantially) independent of impedance in the return circuit path 320.

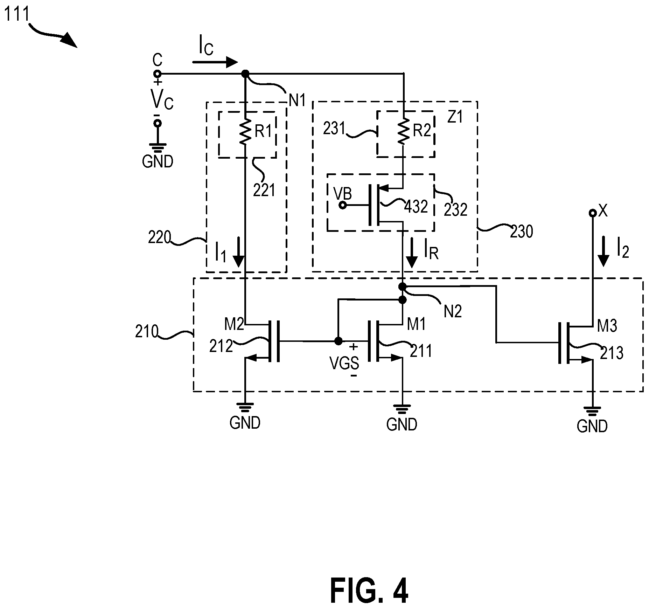

**FIG. 4** illustrates an interface circuit 111 according to an embodiment. Component 232 may comprise a PFET 432. The gate of PFET 432 receives a bias voltage VB (e.g., a voltage between one and two volts). The impedance of component 232 may therefore be determined, at least in part, by the area, bias voltage, and specific on-resistance of PFET 432. The drain of PFET 432 is electrically coupled to the drain of diode connected NFET 211.

Component 231 may comprise resistor R2 electrically coupled to the source of PFET 432. Resistor R2 may have a resistance value (e.g., three hundred ohms) selected to protect components (e.g., PFET 432) from electrostatic discharge (ESD). Therefore, resistor R2 may also be referred to as ESD resistor R2.

As discussed herein, reducing the resistance of ESD resistor R2 and impedance (on resistance) of PFET 432 may be impractical; therefore, impedance Z1 of circuit path 230 may be limited to a minimum practical value.

Component 221 may comprise resistor R1 connected between node N1 and the drain of NFET 212. Resistor R1 may also be an ESD resistor R1 with a resistance selected to protect components (e.g., NFET 212) from electrostatic discharge (ESD).

According to the teachings herein, the connection of return circuit path 220 at node N1 provides shunt feedback which may reduce input impedance $Z_{IN}$ relative to impedance Z1. For instance, if scale factor M1 is five and scale factor M2 is forty-five, then the input impedance $Z_{IN}$ may be a factor of ten lower than impedance Z1. Also, as discussed above, the input impedance $Z_{IN}$ may be independent, or substantially independent of the impedance relating to return path 220 (e.g., resistor R1).

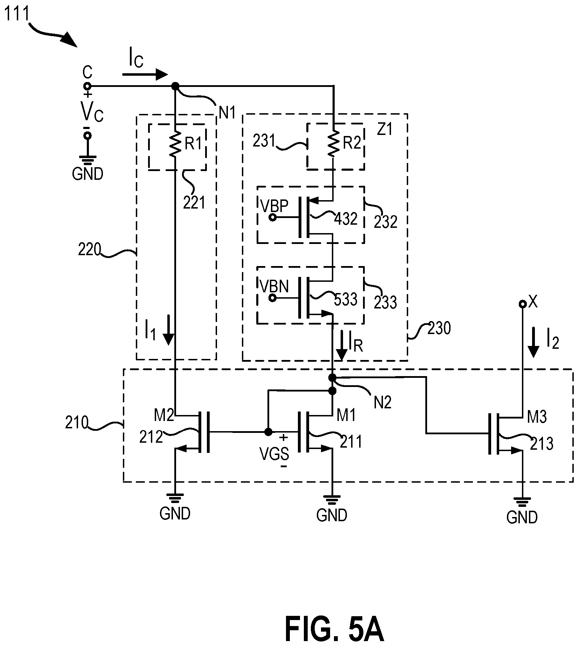

**FIG. 5A** illustrates an interface circuit 111 according to another embodiment. Interface circuit 111 of FIG. 5A is like that of FIG. 4 except circuit path 230 includes component 233. Component 233 comprises an NFET 533. The drain of PFET 432 is electrically coupled to the drain of NFET 533; and the source of NFET 533 is electrically coupled to the drain of diode connected NFET 211. The gate of NFET 533 receives bias voltage VBN so that NFET 533 limits current $I_R$. This may advantageously reduce the risk of overcurrent and/or thermal faults due to excessive input current Ic at interface node C.

Additionally, the gate of PFET 432 receives voltage VBP instead of bias voltage VB. Unlike bias volage VB, voltage VBP may be varied and/or switched to have more than one value. For instance, voltage VBP may be switched between a first value (e.g., one to two volts) and a second value (e.g., supply voltage VP). The first value of voltage VBP may be applied so that the circuit path 230 conducts current $I_R$ during normal operating conditions; and the second value of voltage VBP may applied to block current $I_R$ during a fault condition (e.g., during an overtemperature condition).

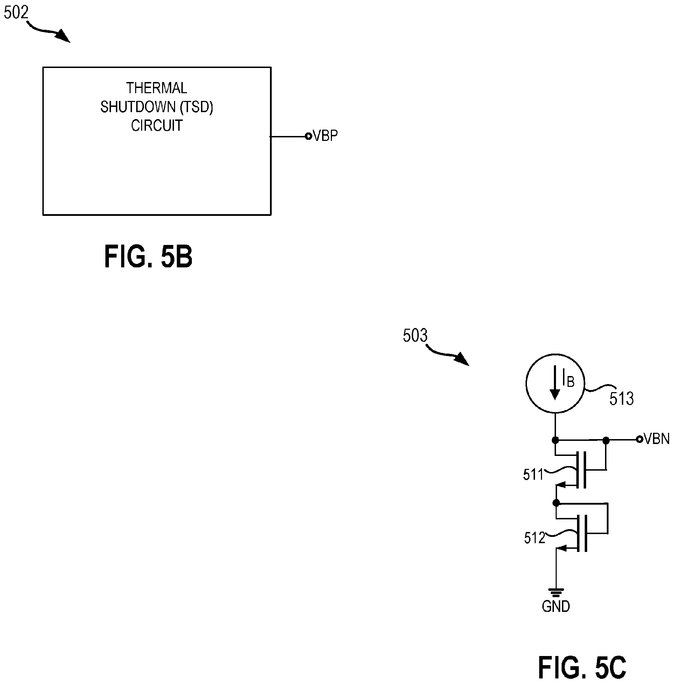

**FIG. 5B** illustrates a thermal shutdown circuit 502 according to the embodiment of FIG. 5A. Thermal shutdown circuit 502 may provide voltage VBP to the gate of PFET 432. As discussed above, thermal shutdown circuit 502 may vary and/or switch the value of voltage VBP. For instance, the thermal shutdown circuit may cause voltage VBP to have a value of one to two volts during normal operation and a value of supply voltage VP during a fault (either overcurrent or thermal overload).

**FIG. 5C** illustrates a bias circuit 503 according to the embodiment of FIG. 5A. Bias circuit 503 may generate bias voltage VBN to limit current $I_R$ in circuit path 230. Limiting current $I_R$ may, in turn, advantageously limit input current Ic to prevent an overcurrent and/or fault condition at interface input C. Bias circuit 503 includes NFET 511, NFET 512, and current source 513. As illustrated, NFET 511 and NFET 512 are diode connected and in series between current source 513 and ground GND. Current source 513 provides current $I_B$, and in response, bias voltage VBN is generated at the gate/drain node of diode connected NFET 511.

CONCLUSION

The above description of illustrated examples of the present disclosure, including what is described in the Abstract, is not intended to be exhaustive or to be limitation to the precise forms disclosed. While specific embodiments of, and examples for an interface circuit using mirrored current feedback to reduce input impedance are described herein for illustrative purposes, various equivalent modifications are possible without departing from the broader spirit and scope of the present disclosure. Indeed, it is appreciated that the specific example voltages, currents, frequencies, power range values, times, etc., are provided for explanation purposes and that other values may also be employed in other embodiments and examples in accordance with the teachings herein.

The foregoing description may refer to elements or features as being "connected" or "coupled" together. As used herein, unless expressly stated otherwise, "connected" or "electrically connected" means that one element/feature is directly or indirectly connected to another element/feature, and not necessarily mechanically. Likewise, unless expressly stated otherwise, "coupled" or "electrically coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

Moreover, conditional language used herein, such as, among others, "can," "could," "might," "may," "e.g.," "for example," "such as" and the like, unless specifically stated otherwise or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or that one or more embodiments necessarily include logic for deciding whether these features, elements and/or states are included or are to be performed in any particular embodiment.

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions, and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

EMBODIMENTS

Although the present invention is defined in the attached claims, it should be understood that the present invention can also (alternatively) be defined in accordance with the following embodiments:

1. An interface circuit comprising:

an interface input;
a current mirror comprising a current mirror input and a first current mirror output;
an input circuit path electrically coupled between the interface input and the current mirror input; and
a return circuit path electrically coupled between the interface input and the first current mirror output.

2. The interface circuit of embodiment 1, wherein the input circuit path comprises an electrostatic discharge (ESD) resistor.

3. The interface circuit of embodiment 1, wherein the return circuit path comprises an electrostatic discharge (ESD) resistor.

4. The interface circuit of embodiment 1, wherein the current mirror is configured to receive a reference current at the current mirror input via the input circuit path and to provide a return current from the first current mirror output to the interface input via the return circuit path.

5. The interface circuit of embodiment 4, wherein an input impedance of the interface input is determined, at least in part, by an impedance of the input circuit path and by a return ratio of the return current to the reference current.

6. The interface circuit of embodiment 5, wherein the input impedance decreases as the return ratio increases.

7. The interface circuit of embodiment 4, wherein the input circuit path comprises a P-channel field-effect transistor (PFET).

8. The interface circuit of embodiment 7, wherein the PFET is configured to receive a fixed reference voltage.

9. The interface circuit of embodiment 7, wherein the PFET is configured to open the input circuit path during a thermal shutdown (TSD) condition.

10. The interface circuit of embodiment 4, wherein the input circuit path comprises an N-channel field-effect transistor (NFET).

11. The interface circuit of embodiment 10, wherein the NFET is configured to receive a bias voltage and to limit the reference current.

12. The interface circuit of embodiment 4 further comprising an interface output electrically coupled to a second current mirror output and configured to provide an output current proportional to the reference current.

13. The interface circuit of embodiment 12, wherein the current mirror further comprises:

a diode connected N-channel field-effect transistor (NFET) configured to receive the reference current and to generate a gate voltage; and
a first NFET configured to receive the gate voltage and to provide the return current.

14. A closed loop system comprising:

a system input;
a current mirror configured to receive a reference current and to provide a return current;
an input circuit path electrically coupled to the system input and configured to conduct the reference current; and
a return circuit path electrically coupled to the system input and configured to conduct the return current such that an impedance of the closed loop system is less than an impedance of the input circuit path and determined, at least in part, by a return ratio.

15. The closed loop system of embodiment 14, wherein an input current of the closed loop system is determined, at least in part, by a sum of the return current and the reference current, and the return ratio is determined, at least in part, by a ratio of the return current to the reference current.

16. The closed loop system of embodiment 14, wherein the current mirror comprises:

a diode connected transistor configured to receive the reference current, and in response to provide a reference voltage; and

a first transistor configured to receive the reference voltage and to provide the return current.

17. The closed loop system of embodiment 16, wherein the diode connected transistor is a diode connected N-channel field-effect transistor (NFET) and the first transistor is a first NFET.

18. The closed loop system of embodiment 16, wherein the diode connected transistor is a diode connected P-channel field-effect transistor (PFET) and the first transistor is a first PFET.

19. The closed loop system of embodiment 16, wherein

the reference voltage is determined, at least in part, by a transconductance of the diode connected transistor; and

the return current is determined, at least in part, by a transconductance of the first transistor.

20. The closed loop system of embodiment 19, wherein the return ratio is determined, at least in part, by a ratio of the transconductance of the first transistor to the transconductance of the diode connected transistor.

**Claims**

1. An interface circuit comprising:

an interface input;

a current mirror comprising a current mirror input and a first current mirror output;

an input circuit path electrically coupled between the interface input and the current mirror input; and

a return circuit path electrically coupled between the interface input and the first current mirror output.

2. The interface circuit of claim 1, wherein either the input circuit path or the return circuit path comprises an electrostatic discharge (ESD) resistor.

3. The interface circuit of claim 1, wherein the current mirror is configured to receive a reference current at the current mirror input via the input circuit path and to provide a return current from the first current mirror output to the interface input via the return circuit path.

4. The interface circuit of claim 3, wherein an input impedance of the interface input is determined, at least in part, by an impedance of the input circuit path and by a return ratio of the return current to the reference current, and optionally wherein the input impedance decreases as the return ratio increases.

5. The interface circuit of claim 3, wherein the input circuit path comprises a P-channel field-effect transistor (PFET), and optionally wherein the PFET is coupled to receive a fixed reference voltage.

6. The interface circuit of claim 5, wherein the PFET is configured to open the input circuit path during a thermal shutdown (TSD) condition.

7. The interface circuit of claim 3, wherein the input circuit path comprises an N-channel field-effect transistor, and optionally wherein the N-channel field-effect transistor is configured to receive a bias voltage and to limit the reference current.

8. The interface circuit of claim 3 further comprising an interface output electrically coupled to a second current mirror output and configured to provide an output current proportional to the reference current, and optionally wherein the current mirror further comprises a diode connected N-channel field-effect transistor configured to receive the reference current and to generate a gate voltage; and

a first N-channel field-effect transistor configured to receive the gate voltage and to provide the return current.

9. A closed loop system comprising the interface circuit of any preceding claim, wherein:

the interface input is a system input;

the current mirror is configured to receive a reference current at the current mirror input and to provide a return current at the first current mirror output;

the input circuit path is configured to conduct the reference current; and
the return circuit path is configured to conduct the return current such that an impedance of the closed loop system is less than an impedance of the input circuit path and determined, at least in part, by a return ratio.

10. The closed loop system of claim 9, wherein an input current of the closed loop system is determined, at least in part, by a sum of the return current and the reference current, and the return ratio is determined, at least in part, by a ratio of the return current to the reference current.

11. The closed loop system of claim 9, wherein the current mirror comprises:

a diode connected transistor configured to receive the reference current, and in response to provide a reference voltage; and
a first transistor configured to receive the reference voltage and to provide the return current.

12. The closed loop system of claim 11, wherein the diode connected transistor is a diode connected N-channel field-effect transistor and the first transistor is a first N-channel field-effect transistor.

13. The closed loop system of claim 11, wherein the diode connected transistor is a diode connected P-channel field-effect transistor and the first transistor is a first P-channel field-effect transistor.

14. The closed loop system of claim 11, wherein

the reference voltage is determined, at least in part, by a transconductance of the diode connected transistor; and
the return current is determined, at least in part, by a transconductance of the first transistor, and
optionally wherein the return ratio is determined, at least in part, by a ratio of the transconductance of the first transistor to the transconductance of the diode connected transistor.

FIG. 1

**FIG. 2A**

EP 4 632 525 A2

111

$I_C$

C

$V_C$

GND

N1

220

230

Z1

X

$I_1$

$I_R$

$I_2$

IREF

202

203

210

$I_1 = K I_R$

$I_2 = N I_R$

CURRENT MIRROR

## FIG. 2B

**FIG. 2C**

FIG. 3A

FIG. 3B

**FIG. 3C**

EP 4 632 525 A2

**FIG. 4**

FIG. 5A

502

FIG. 5B

503

FIG. 5C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63633320